# EUROPEAN PATENT SPECIFICATION

(11) **EP 2 696 503 B1**
(45) Date of publication and mention of the grant of the patent: **09.11.2016**
(21) Application number: 12179367.3
(22) Date of filing: 06.08.2012
(51) Int. Cl.: H03K 17/22

(54) **Power on reset circuit**
Strom auf einer Reset-Schaltung
Circuit de réinitialisation à la mise sous tension

(43) Date of publication of application: 12.02.2014
(73) Proprietor: Rohm Co., Ltd., Kyoto-shi, Kyoto 615-8585 (JP)
(72) Inventor: Mladenova, Irina, 47877 Willich (DE)
(74) Representative: Isarpatent

(56) References cited:
- DE-A1- 10 330 618
- US-A- 4 385 243
- US-A- 4 581 552
- US-A- 6 107 847

## Description

The invention relates to a power on reset circuit adapted to generate a power on reset signal.

In many applications and digital circuits which contain astable circuits such as flip-flops circuits an initial reset signal is required which guarantees that the respective digital circuit is set in a proper way during a power-up process. This initial reset signal is generated by a power on reset circuit.

Conventional power on reset circuits use a voltage reference which is compared with a partial voltage of the supply voltage of the respective circuit.

However, these conventional power on reset circuits using a voltage reference have the disadvantage that if the power-up is performed too fast the generated power on reset signal may not last long enough to provide a proper reset of the respective digital circuit. Furthermore, power bouncing can occur when a false reset signal may be produced by such a conventional power on reset circuit.

Further, there are known power on reset circuits containing a RC chain which defines the delay after power-up has been applied. The disadvantage of such a conventional power up reset circuit is that when the slope of the power-up is high the resistor and capacitor of the RC chain need a high resistance and capacitance value so that these components consume a lot of area when integrated on a chip.

Document US 4 385 243 A discloses an automatic reset circuit for providing automatically a reset signal to circuit elements which are required to be reset when a power supply is turned on. The reset circuit includes latching means having first and second states and is responsive to a level detection signal signalizing an increase in value of a power supply voltage. The latching means comprise a npn transistor and a pnp transistor. The base of the npn transistor is connected to the collector of the pnp transistor. The base of the pnp transistor is connected to the collector of the npn transistor.

Document DE 103 30 618 A1 discloses a built-in electronic device and an integrated circuit for the detection and the saving of voltage drops. The circuit includes a pnp transistor and a npn transistor, wherein the base of one of the transistors serves as an input terminal for a reset impulse. The emitter voltage of the pnp transistor signalizes a voltage drop. The base of the npn transistor is connected to the collector of the pnp transistor. The base of the pnp transistor is connected to the collector of the npn transistor.

It is an object of the present invention to provide a power on reset circuit with reduced steady-state power consumption.

This object is achieved by a power on reset circuit comprising the features of claim 1.

An advantage of said power on reset circuit according to the present invention is that no constant DC current is flowing through said power on reset circuit after the power on reset has been performed so that the energy consumption is low.

A further advantage of the power on reset circuit according to the present invention is that a threshold voltage can be changed by small changes in the layout of the integrated thyristor of the power on reset circuit.

In a further possible embodiment of the power on reset circuit according to the present invention the thyristor integrated in said power on reset circuit is formed by complementary bipolar transistors.

In a further possible embodiment of the power on reset circuit according to the present invention the thyristor integrated in said power on reset circuit comprises a bipolar npn transistor and a bipolar pnp transistor, wherein a collector of the bipolar npn transistor is connected to a base of the bipolar pnp transistor, and wherein a collector of said bipolar pnp transistor is connected to a base of the bipolar npn transistor and forms a latch-up signal output by said power on reset circuit.

In a possible embodiment of the power on reset circuit according to the present invention the latch-up signal output of said power on reset circuit is connected to a trigger flip-flop of the integrated circuit.

In a further possible embodiment of the power on reset circuit according to the present invention the trigger flip-flop comprises a logical signal output providing a logical high power on reset signal in response to a latched-up voltage at the latch-up signal output of the power on reset circuit.

In a further possible embodiment of the power on reset circuit according to the present invention the logical signal output of the trigger flip-flop is connected via a capacitor having a predetermined capacitance to a reference potential.

In a still further embodiment of the power on reset circuit according to the present invention the logical signal output of said trigger flip-flop is connected to an enable signal input of said power on reset circuit.

In a further possible embodiment of the power on reset circuit a logical high power on reset signal provided by said trigger flip-flop in response to a latched-up voltage at the latch-up signal output of said power on reset circuit is applied as a logical high enable signal to a gate of the MOSFET integrated in said power on reset circuit and being connected to the enable signal input to switch off said MOSFET and the thyristor integrated in said power on reset circuit.

In a further possible embodiment of the power on reset circuit according to the present invention the MOSFET integrated in said power on reset circuit is a P-MOSFET which is initially conducting until a logical high enable signal is applied to the gate of the P-MOSFET.

In a still further embodiment of the power on reset circuit according to the present invention the MOSFET integrated in the power on reset circuit is provided between a power supply terminal of said power on reset circuit and the emitter of the bipolar pnp transistor of the thyristor integrated in said power on reset circuit.

In a still further embodiment of the power and reset circuit according to the present invention the npn transistor of the thyristor integrated in said power on reset circuit comprises a p-base formed by a p-doped p-well being embedded in a deep n-well which forms the collector of the npn transistor and which is connected to the power supply terminal of the power on reset circuit to receive a positive power supply voltage.

In a further embodiment of the power on reset circuit according to the present invention the pnp transistor of the thyristor integrated in said power on reset circuit comprises a n-base formed by said n-doped deep n-well and connected to the power supply terminal of said power on reset circuit and a second p-doped connection well of said P-MOSFET which is embedded in said n-doped n-well and is connected to the p-doped connection well which forms the emitter of said npn transistor.

In a further possible embodiment of the power on reset circuit according to the present invention the power on reset circuit further comprises a first integrated resistor which is provided between the collector of the bipolar npn transistor being connected to the basis of the bipolar pnp transistor and the power supply terminal of said power on reset circuit and which is formed by a parasitic resistance of said n-doped deep n-well.

In a further possible embodiment of the power on reset circuit according to the present invention the power on reset circuit further comprises a second integrated resistor which is provided between the collector of the bipolar pnp transistor being connected to the base of the bipolar npn transistor and the reference potential terminal of said power on reset circuit and which is formed by a parasitic resistance of said p-doped p-well embedded in said n-doped deep n-well.

In a further possible embodiment of the power on reset circuit the trigger flip-flop is a RS flip-flop having a S input connected to the latched-up signal output of said power on reset circuit.

In a further possible embodiment the RS trigger flip-flop is formed by logical NOR cells.

In the following possible embodiments of the power on reset circuit are explained in more detail with reference to the enclosed figures.
- Fig. 1: shows a circuit diagram of the power on reset circuit according to a possible embodiment of the present invention connected to a trigger flip-flop for generating a power on reset signal during a power-up process;
- Fig. 2: shows a circuit diagram of a component within a power on reset circuit according to a possible embodiment of the present invention which can be integrated on a chip;
- Fig. 3: shows a layout cross-section of an integrated power on reset circuit in an integrated thyristor structure latching up a power on reset signal according to a possible embodiment of the present invention.

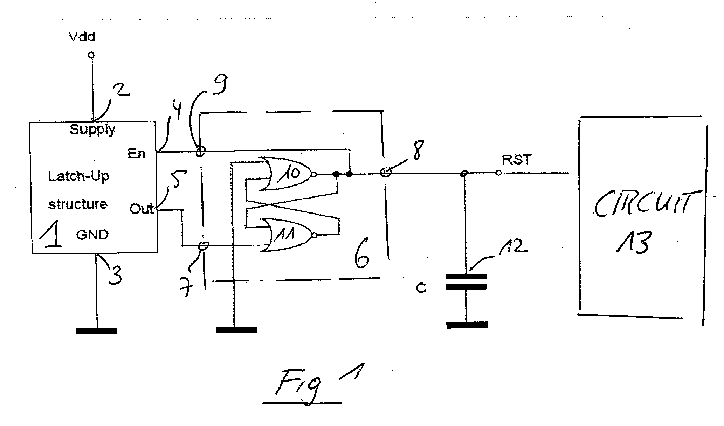

As can be seen in Fig. 1 the power on reset circuit 1 is provided to generate a power on reset signal RST during a power-up of a power supply voltage V_{DD} of an integrated circuit IC. The power on reset circuit 1 can also be integrated in the respective integrated circuit IC. The power on reset circuit 1 comprises a supply voltage terminal 2 and a reference potential terminal 3 which can be connected to a reference potential such as ground GND. The power on reset circuit 1 further comprises an enable signal input 4 and a latch-up signal output 5 as shown in Fig. 1. The power on reset circuit 1 according to the present invention generates a power of reset signal RST during power-up which is latched-up by a thyristor integrated in said power on reset circuit 1. The latch-up signal output 5 of the power on reset circuit 1 is connected to a trigger flip-flop 6 as shown in Fig. 1, wherein the trigger flip-flop 6 can also be integrated in the respective integrated circuit IC. In the shown embodiment the trigger flip-flop 6 is formed by an RS flip-flop having an S input 7 connected to the latch-up signal output 5 of the power on reset circuit 1 as shown in Fig. 1. Further, the enable signal input 4 of the latch-up power on reset circuit 1 is directly connected to a logical signal output Q via terminal 9 of the trigger flip-flop 6 as shown in Fig. 1. In the shown implementation the trigger flip-flop 6 is formed by two cross-connected NOR gates or NOR cells 10, 11. Further, the logical signal output 8 of the trigger flip-flop 6 is connected in the shown implementation via a capacitor 12 having a predetermined capacitance to a reference potential GND. The trigger flip-flop 6 comprises the logical signal output Q providing a logical high power on reset signal RST in response to a latched-up voltage at the latch-up signal output 5 of the power on reset circuit 1. The signal output 8 of the trigger flip-flop 6 is connected via the capacitor 12 to a reference potential GND so that a signal delay is provided. The reset signal RST is output by the logical signal output 8 of the trigger flip-flop 6 and can be applied to a digital circuit 13 or also an analog circuit 13 which needs a power on reset signal RST through a power-up period of its power supply voltage. The power on reset circuit 1 can be integrated on the same chip as the circuit which gets the reset signal RST.

In an alternative embodiment the power on reset circuit 1 can be formed by a separate integrated circuit which is connected to the circuit receiving the power on reset signal RST via a trigger flip-flop 6 as shown in Fig. 1. The trigger flip-flop 6 can also be integrated in the power on reset circuit 1 or form a separate entity. Further, the capacitor 12 as shown in the embodiment of Fig. 1 can also be integrated in the power on reset circuit 1 along with the trigger flip-flop 6.

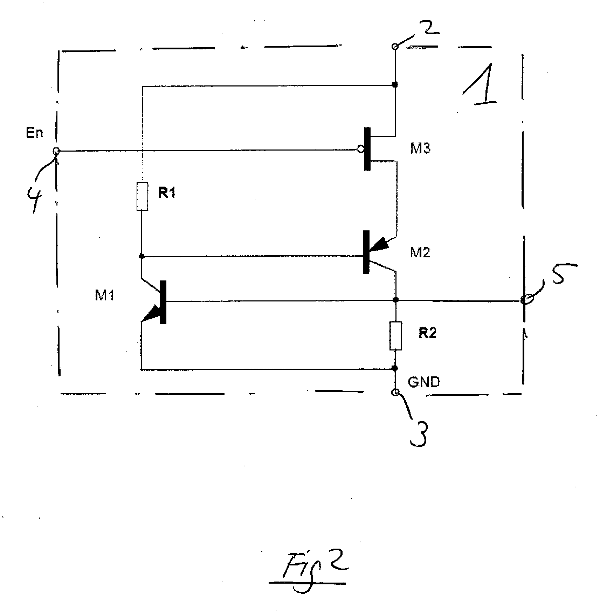

Fig. 2 shows a circuit diagram of a component which can be integrated in the power on reset circuit 1. As can be seen in Fig. 2 the power on reset circuit 1 is latched-up by a thyristor integrated in the power on reset circuit 1. The integrated thyristor is switched off by a MOSFET M3 provided in said power on reset circuit 1 in response to a logical enable signal EN applied to the enable input 4. The thyristor integrated in said power on reset circuit 1 is formed by complementary bipolar transistors M1, M2 as shown in the embodiment of Fig. 2. The integrated thyristor comprises in the shown implementation a bipolar npn transistor M1 and a bipolar pnp transistor M2 as shown in Fig. 2. The collector of the bipolar npn transistor M1 is connected in the shown implementation to the base of the bipolar pnp transistor M2 and the collector of the bipolar pnp transistor M2 is connected to the base of the bipolar npn transistor M1 and forms a latch-up signal output 5 of the power on reset circuit 1. The latch-up signal output 5 of the power on reset circuit 1 as shown in Fig. 2 is connected to a trigger flip-flop 6 such as the trigger flip-flop 6 as shown in Fig. 1. The logical signal output 9 of the trigger flip-flop 6 is connected to the enable signal input 4 of the power on reset circuit 1.

In the shown embodiment a logical high power on reset signal RST is provided by the trigger flip-flop 6 in response to a latched-up voltage at the latch-up signal output 5 of the power on reset circuit 1 and is applied as a logical high enable signal EN to the gate G of the MOSFET M3 integrated in the power on reset circuit 1. As can be seen in Fig. 2 the gate of the MOSFET M3 is connected to the enable signal input EN (4) and a logical high power on reset signal provided by the trigger flip-flop 6 in response to a latched-up voltage at the latch-up signal output 5 of the power on reset circuit 1 is applied as a logical high enable signal EN to the gate of the MOSFET M3 to switch off the MOSFET M3 and the thyristor integrated in said power on reset circuit 1 comprising the bipolar transistors M1, M2. The MOSFET M3 integrated in said power on reset circuit 1 is in the shown embodiment a P-MOSFET which is initially conducting until a logical high enable signal EN is applied to the gate of the P-MOSFET M3. The MOSFET M3 integrated in said power on reset circuit 1 is provided between the power supply terminal 2 of the power on reset circuit 1 and the emitter of the bipolar pnp transistor M2 of the thyristor integrated in the power on reset circuit 1.

As can be seen in Fig. 2 the power on reset circuit 1 comprises a first integrated resistor R1 which is provided between the collector of the bipolar npn transistor M1 and connected to the base of the bipolar pnp transistor M2 and the power supply terminal 2 of said power on reset circuit 1 and can be formed in a possible implementation by a parasitic resistance of a n-doped deep n-well.

The power on reset circuit 1 further comprises a second resistor R2 which is provided between the collector of the bipolar pnp transistor M2 being connected to the base of the bipolar npn transistor M1 and the reference potential terminal 3 of the power on reset circuit 1. Also the second integrated resistor R2 can be formed by a parasitic resistance, for example by a p-doped p-well embedded in a n-doped deep n-well.

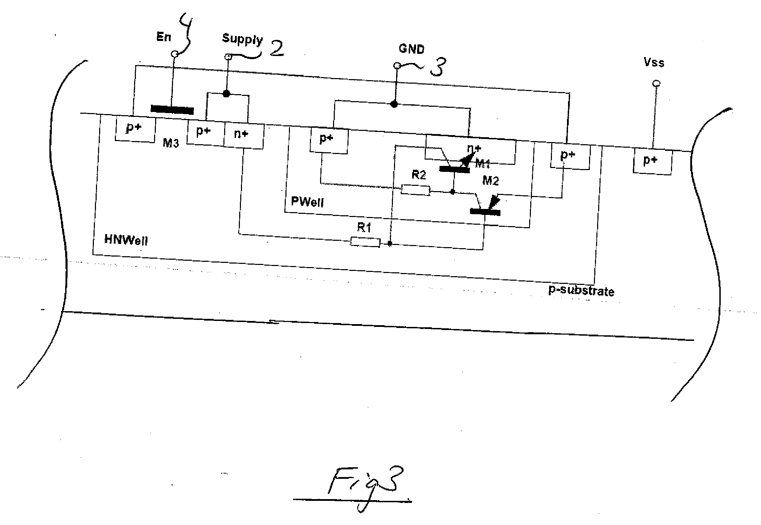

Fig. 3 shows a layout cross-section of a possible implementation of a power on reset circuit 1 according to the present invention integrated in an integrated circuit IC.

As can be seen in Fig. 3 the npn transistor M1 of the thyristor integrated in the power on reset circuit 1 comprises a p-base formed by a p-doped p-well being embedded in a deep n-well which forms the collector of the npn transistor M1 and which is connected to the power supply terminal 2 of said power on reset circuit 1 to receive a positive power supply voltage V_{DD}. The pnp transistor M2 of the thyristor integrated in said power on reset circuit 1 comprises a n-base formed by the n-doped deep n-well in which the p-doped p-well is embedded. The p-well forms the collector of the pnp transistor M2 and is connected to a reference potential GND of the terminal 3 of said power on reset circuit 1. Further, the gate of the P-MOSFET M3 integrated in the power on reset circuit 1 controls an electrical current flowing between a first p-doped connection well which is embedded in the n-doped deep n-well and connected to the power supply terminal 2 of the power on reset circuit 1 and a second p-doped connection well which is embedded in the n-doped n-well which is connected to a p-doped connection well which forms the emitter of the pnp transistor M2. Further, Fig. 3 shows a first integrated resistor R1 provided between the collector of the bipolar npn transistor M1 being connected to the base of the bipolar pnp transistor M2 and the power supply terminal 2 of the power on reset circuit 1 and which is formed by a parasitic resistance of the n-doped deep n-well.

Further, a second integrated resistor R2 is provided between the collector of the bipolar pnp transistor M2 being connected to the base of the bipolar npn transistor M1 and the reference potential terminal of said power on reset circuit 1 and formed by a parasitic resistance of the p-doped p-well embedded in the n-doped deep n-well.

The power on reset circuit 1 shown in the embodiment of Figs. 1, 2, 3 can be implemented in a possible implementation in a modified CMOS structure with additional masks for a high voltage n-well and p-well which is suitable for production of high voltage circuits such as Triple-well. In the implementation as shown in Fig. 3 the parasitic resistances R1, R2 are used deliberately for latching up the power on reset signal RST and form part of a thyristor structure integrated within the power on reset circuit 1. When the PMOS transistor M3 is open, i.e. switched off, a supply voltage V_{DD} is applied at bipolar transistor M2. The layout shown in Fig. 3 can be adjusted to trigger itself in latch-up for some desired value of the supply voltage V_{DD}. When bipolar transistors M1, M2 are fully opened, an electrical current starts to flow through them. The voltage drop on the parasitic resistor R2 becomes high enough to be seen as a logical high signal applied to the S input of the RS trigger flip-flop 6 as shown in Fig. 1 comprising two NOR logical cells. The trigger flip-flop 6 which was initially set to LOW at its logical output 8 changes its status to logical HIGH output at its logical output 8. When the switching transistor M3 closes, the electrical current stops to flow through the latch-up structure of the integrated power on reset circuit 1.

The power on reset circuit 1 according to the present invention as shown in the embodiments of Figs. 1, 2, 3 has the advantage that it does occupy only a very small area when integrated on a chip. Moreover, no constant DC electrical current is flowing once the power on reset process has been performed. The time switch delay provided by the power on reset circuit 1 can be changed by small changes in the layout of the latch-up structure integrated in the power on reset circuit 1.

## Claims

1. A power on reset, POR, circuit (1) adapted to generate a power on reset signal (RST) during a power-up of a power supply voltage (V_{DD}) of an integrated circuit, (IC), and comprising a thyristor and a trigger flip-flop (6)
**characterized in that** said power on reset circuit (1) is adapted for said power on reset signal (RST) to be latched up, via the trigger flip-flop (6) by the thyristor integrated in said power on reset circuit (1), the thyristor comprising a latch-up signal output (5) connected to an input of the trigger flip-flop (6);
wherein said thyristor is adapted to be switched off by a MOSFET (M3) integrated in said POR circuit (1), in response to a logical enable signal (EN) received by said POR circuit (1) from a signal output (8) of the trigger flip-flop; and
wherein the power on reset signal (RST) is generated at said signal output (8) of the trigger flip-flop (6) so that it can be applied to said integrated circuit (IC).

2. The power on reset circuit according to claim 1,
wherein said thyristor is formed by complementary bipolar transistors (M1, M2).

3. The power on reset circuit according to claim 2,
wherein said thyristor comprises
a bipolar npn transistor (M1) and
a bipolar pnp transistor (M2), wherein a collector (Coll) of said bipolar npn transistor (M1) is connected to a base of said bipolar pnp transistor (M2), and wherein a collector of said bipolar pnp transistor (M2) is connected to a base of said bipolar npn transistor (M1) and forms the latch-up signal output (5) of said POR circuit (1).

4. The power on reset circuit according to claim 3,
wherein the signal output (8) of the trigger flip-flop (6) is a logical signal output (8) providing a logical high power on reset signal (RST) in response to a latched-up voltage at the latch-up signal output (5) of said POR circuit (1).

5. The power on reset circuit according to claim 4,
wherein said logical signal output (8) of said trigger-flip flop (6) is connected via a capacitor (12) having a predetermined capacitance (C) to a reference potential (GND).

6. The power on reset circuit according to claim 5,
wherein said logical high power on reset signal (RST) provided by said trigger-flip flop (6) in response to a latched-up voltage at the latch-up signal output (5) of said POR circuit (1) is applied as a logical high enable signal to a gate (G) of said MOSFET (M3) integrated in said POR circuit (1) and being connected to said logical enable signal to switch off said MOSFET (M3) and the thyristor.

7. The power on reset circuit according to claim 6,
wherein said MOSFET (M3) integrated in said POR circuit (1) is a P-MOSFET which is adapted to be initially conducting until a logical high enable signal is applied to the gate (G) of said P-MOSFET (M3).

8. The power on reset circuit according to claim 6 or 7, wherein the MOSFET (M3) integrated in said POR circuit (1) is provided between a power supply terminal (2) of
said POR circuit (1) and the emitter of said bipolar pnp transistor (M2) of said thyristor.

## Patentansprüche

1. Einschalt-Rücksetzschaltung (1), POR-Schaltung, die dafür ausgelegt ist, beim Einschalten einer Versorgungsspannung (V_{DD}) einer integrierten Schaltung (IC) ein Einschalt-Rücksetzsignal (RST) zu erzeugen, und einen Thyristor und einen Trigger-Flipflop (6) umfasst, **dadurch gekennzeichnet, dass** die Einschalt-Rücksetzschaltung (1) dafür ausgelegt ist, das Einschalt-Rücksetzsignal (RST) über den Trigger-Flipflop (6) durch den Thyristor, der in die Einschalt-Rücksetzschaltung (1) integriert ist, einzurasten, wobei der Thyristor einen Latch-up-Signalausgang (5) umfasst, der mit einem Eingang des Trigger-Flipflops (6) verbunden ist;
wobei der Thyristor dafür ausgelegt ist, als Reaktion auf ein logisches Freigabesignal (EN), das von der POR-Schaltung (1) von einem Signalausgang (8) des Trigger-Flipflops empfangen wird, von einem MOSFET (M3), der in die POR-Schaltung (1) integriert ist, ausgeschaltet zu werden; und
wobei das Einschalt-Rücksetzsignal (RST) an dem Signalausgang (8) des Trigger-Flipflops erzeugt wird, so dass es an die integrierte Schaltung (IC) angelegt werden kann.

2. Einschalt-Rücksetzschaltung nach Anspruch 1, wobei der Thyristor durch komplementäre bipolare Transistoren (M1, M2) gebildet ist.

3. Einschalt-Rücksetzschaltung nach Anspruch 2, wobei der Thyristor Folgendes umfasst:
einen bipolaren npn-Transistor (M1) und
einen bipolaren pnp-Transistor (M2), wobei ein Kollektor (Coll) des bipolaren npn-Transistors (M1) mit einer Basis des bipolaren pnp-Transistors (M2) verbunden ist und wobei ein Kollektor des bipolaren pnp-Transistors (M2) mit einer Basis des bipolaren npn-Transistors (M1) verbunden ist und den Latch-up-Signalausgang (5) der POR-Schaltung (1) bildet.

4. Einschalt-Rücksetzschaltung nach Anspruch 3, wobei der Signalausgang (8) des Trigger-Flipflops (6) ein logischer Signalausgang (8) ist, der als Reaktion auf eine eingerastete Spannung an dem Latch-up-Signalausgang (5) der POR-Schaltung (1) ein logisches Hoch-Einschalt-Rücksetzsignal (RST) bereitstellt.

5. Einschalt-Rücksetzschaltung nach Anspruch 4, wobei der logische Signalausgang (8) des Trigger-Flipflops (6) über einen Kondensator (12), der eine vorgegebene Kapazität (C) aufweist, mit einem Referenzpotential (GND) verbunden ist.

6. Einschalt-Rücksetzschaltung nach Anspruch 5, wobei das logische Hoch-Einschalt-Rücksetzsignal (RST), das von dem Trigger-Flipflop (6) als Reaktion auf eine eingerastete Spannung an dem Latch-up-Signalausgang (5) der POR-Schaltung (1) bereitgestellt wird, als ein logisches Hoch-Freigabesignal an ein Gate (G) des MOSFETs (M3), der in die POR-Schaltung (1) integriert ist, angelegt wird und mit dem logischen Freigabesignal verbunden ist, um den MOSFET (M3) und den Thyristor auszuschalten.

7. Einschalt-Rücksetzschaltung nach Anspruch 6, wobei der MOSFET (M3), der in die POR-Schaltung (1) integriert ist, ein P-MOSFET ist, der dafür ausgelegt ist, zunächst leitend zu sein, bis ein logisches Hoch-Freigabesignal auf das Gate (G) des P-MOSFETs (M3) angelegt wird.

8. Einschalt-Rücksetzschaltung nach Anspruch 6 oder 7, wobei der MOSFET (M3), der in die POR-Schaltung (1) integriert ist, zwischen einem Stromversorgungsanschluss (2) der POR-Schaltung (1) und dem Emitter des bipolaren pnp-Transistors (M2) des Thyristors vorgesehen ist.

## Revendications

1. Circuit de réinitialisation à la mise sous tension (1), circuit POR, adapté pour générer un signal de réinitialisation à la mise sous tension (RST) pendant le démarrage d'une tension d'alimentation (V_{DD}) d'un circuit intégré, et comprenant un thyristor et une bascule de déclenchement (6),
**caractérisé en ce que** ledit circuit de réinitialisation à la mise sous tension (1) est adapté pour que ledit signal de réinitialisation à la mise sous tension (RST) soit verrouillé, par l'intermédiaire de la bascule de déclenchement (6), par le thyristor intégré dans ledit circuit de réinitialisation à la mise sous tension (1), le thyristor comprenant une sortie de signal de verrouillage (5) reliée à une entrée de la bascule de déclenchement (6) ;
dans lequel ledit thyristor est adapté pour être coupé par un MOSFET (M3) intégré dans ledit circuit POR (1), en réponse à un signal logique de activation (EN) reçu par ledit circuit POR (1) en provenance d'une sortie de signal (8) de la bascule de déclenchement ; et
dans lequel le signal de réinitialisation à la mise sous tension (RST) est généré au niveau de ladite sortie de signal (8) de la bascule de déclenchement (6) de telle sorte qu'il peut être appliqué audit circuit intégré.

2. Circuit de réinitialisation à la mise sous tension selon la revendication 1, dans lequel ledit thyristor est formé par des transistors bipolaires complémentaires (M1, M2).

3. Circuit de réinitialisation à la mise sous tension selon la revendication 2, dans lequel ledit thyristor comprend un transistor bipolaire npn (M1) et un transistor bipolaire pnp (M2), un collecteur (Coll) dudit transistor bipolaire npn (M1) étant relié à une base dudit transistor bipolaire pnp (M2), et un collecteur dudit transistor bipolaire pnp (M2) étant relié à une base dudit transistor bipolaire npn (M1) et formant la sortie de signal de verrouillage (5) dudit circuit POR (1).

4. Circuit de réinitialisation à la mise sous tension selon la revendication 3, dans lequel la sortie de signal (8) de la bascule de déclenchement (6) est une sortie de signal logique (8) fournissant un signal logique élevé de réinitialisation à la mise sous tension (RST) en réponse à une tension verrouillée au niveau de la sortie de signal de verrouillage (5) dudit circuit POR (1).

5. Circuit de réinitialisation à la mise sous tension selon la revendication 4, dans lequel ladite sortie de signal logique (8) de ladite bascule de déclenchement (6) est reliée par l'intermédiaire d'un condensateur (12) ayant une capacité prédéterminée (C) a un potentiel de référence (GND).

6. Circuit de réinitialisation à la mise sous tension selon la revendication 5, dans lequel ledit signal logique élevé de réinitialisation à la mise sous tension (RST) fourni par ladite bascule de déclenchement (6) en réponse à une tension verrouillée au niveau de la sortie de signal de verrouillage (5) dudit circuit POR (1) est appliqué comme un signal logique élevé de déverrouillage à une grille (G) dudit MOSFET (M3) intégré dans ledit circuit POR (1) et étant relié audit signal logique de déverrouillage pour couper ledit MOSFET (M3) et le thyristor.

7. Circuit de réinitialisation à la mise sous tension selon la revendication 6, dans lequel ledit MOSFET (M3) intégré dans ledit circuit POR (1) est un P-MOSFET qui est adapté pour être initialement conducteur jusqu'à ce qu'un signal logique élevé de déverrouillage soit appliqué à la grille (G) dudit P-MOSFET (M3).

8. Circuit de réinitialisation à la mise sous tension selon la revendication 6 ou 7, dans lequel le MOSFET (M3) intégré dans ledit circuit POR (1) est disposé entre une borne d'alimentation (2) dudit circuit POR (1) et l'émetteur dudit transistor bipolaire pnp (M2) dudit thyristor.
